# EUROPEAN PATENT APPLICATION

(11) **EP 1 020 993 A1**
(43) Date of publication of application: **19.07.2000**
(21) Application number: 00300062.7
(22) Date of filing: 06.01.2000
(51) Int. Cl.: H03J 5/24

(54) **Tuner**

(30) Priority: 18.01.1999 JP 963699
(71) Applicant: ALPS ELECTRIC CO., LTD., Ota-ku Tokyo 145 (JP)
(72) Inventor: Yamagata, Yuichiro, c/o Alps Electric Co. Ltd., Tokyo 145 (JP)
(74) Representative: Kensett, John Hinton

(57) **Abstract**

A first high-frequency amplifier (4) having FETs is provided between a first high-frequency circuit part (2) and a mixer (7), a second high-frequency amplifier (5) having FETs is provided between a second high-frequency circuit part (3) and the mixer, and the first high-frequency amplifier (4) or the second high-frequency amplifier (5) is made alternatively operative, thereby switching the receiving band by the two high-frequency amplifiers.

## Description

The present invention relates to a tuner and, more particularly, to a tuner for receiving signals by switching a plurality of bands.

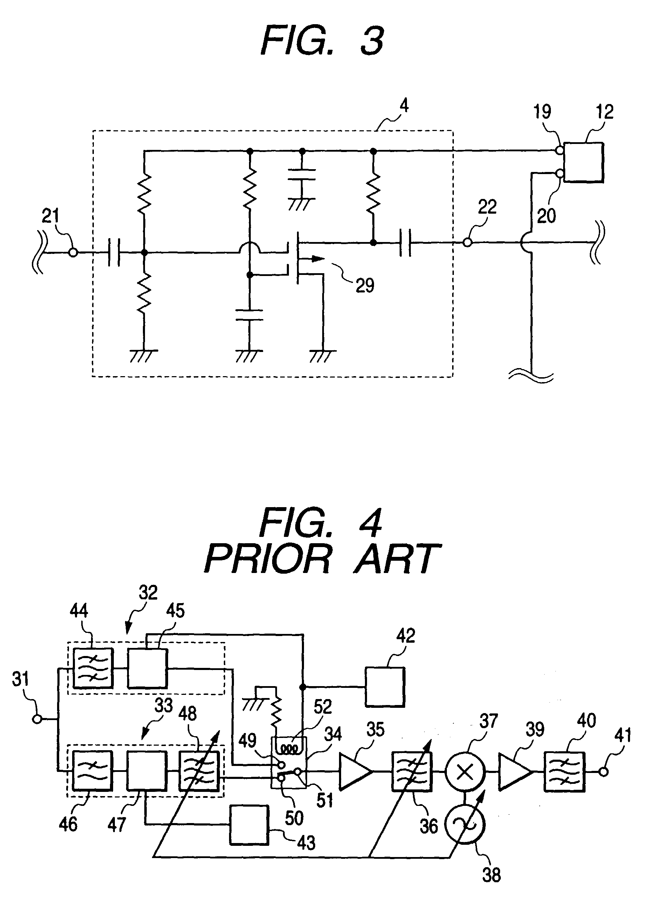

The configuration of a conventional tuner is shown in Fig. 4. The tuner is, for example, a tuner for receiving European digital sound broadcasts by switching a plurality of bands. The tuner receives signals in L band, band 2, and band 3. The frequency band of the L band is from 1,453 MHz to 1,490 MHz, the frequency band of the band 2 is from 88 MHz to 107 MHz, and the frequency band of the band 3 is from 175 MHz to 239 MHz.

The tuner for receiving digital sound broadcast comprises an input terminal 31, a first high-frequency circuit part 32 for frequency converting a signal in the L band, a second high-frequency circuit part 33 for receiving signals in the bands 2 and 3, a relay switch 34, a high-frequency amplifier 35, a first filter 36, a mixer 37, a local oscillator 38, an intermediate frequency amplifier 39, a second filter 40, an output terminal 41, a band switching circuit 42, and a gain control voltage generator 43. The first high-frequency circuit part 32 has a third filter 44 and a down converter 45. A voltage generated from the band switching circuit 42 is applied to the relay switch 34 and the down converter 45. The second high-frequency circuit part 33 has a fourth filter 46, an attenuator 47, and a fifth filter 48. Again control voltage generated from the gain control voltage generator 43 is applied to the attenuator 47.

The relay switch 34 comprises a first input terminal 49, a second input terminal 50, an output terminal 51, and a coil 52. When a voltage is applied from the band switching circuit 42 to the coil 52, the first input terminal 49 and the output terminal 51 are made conductive. Then no voltage is applied, the second input terminal 50 and the output terminal 51 are made conductive.

The receiving frequency is selected by changing the oscillation frequency of the local oscillator 38 by channel selecting means (not shown). Each of the first filter 36 and the fifth filter 48 is a variable bandpass filter and the center frequency of the pass band changes according to a change in the oscillation frequency of the local oscillator 8.

In the case of receiving the signal in the band 2 or 3, the gain control voltage generator 43 generates a gain control voltage corresponding to the level of the signal to adjust the attenuation amount of the attenuator 47 by the gain control voltage so as to obtain an almost constant output. In the case of receiving the signal in the L band, the gain control voltage to maximize the attenuation amount of the attenuator 47 is generated. The second filter 40 is a bandpass filter and passes only an intermediate frequency signal. The third filter 44 is a bandpass filter and passes only the band signal in the L band. The fourth filter 46 is a low pass filter and passes only the band signal in the band 2 or 3. The signal in any of the bands is supplied to the input terminal 31.

Upon reception of the signal in the L band, a voltage is applied from the band switching circuit 42 to the down converter 45 and the relay switch 34, the down converter 45 enters the operating state, a current is passed to the coil 52 of the relay switch 34, and the first input terminal 49 and the output terminal 51 are made conductive. The frequency of the signal in the L band which has been passed through the third filter 44 is converted by the down converter 45 to a low frequency of 1,300 MHz and the resultant signal is sent to the relay switch 34. At this time, since the first input terminal 49 and the output terminal 51 of the relay switch 34 are conducting, the signal in the L band passed through the relay switch 34 is amplified by the high-frequency amplifier 35. The amplified signal is passed through the first filter 36 and is frequency converted by the mixer 37 and the local oscillator 38 into an intermediate frequency signal of 38.9 MHz. The intermediate frequency signal is amplified by the intermediate frequency amplifier 39 and the amplified signal is passed through the second filter 40 and outputted from the output terminal 41.

Since the attenuation amount of the attenuator 47 in the second high-frequency circuit part 33 is made maximum by a voltage from the gain control voltage generator 43, even when the signal in the band 2 or 3 is supplied to the attenuator 37, the level of the signal in the band 2 or 3 passing through the attenuator 47 is made extremely low. Even when a leakage at a slight level occurs and a leaked signal is supplied to the second input terminal 50 in the relay switch 34, since the second input terminal 50 is not conducting with the output terminal 51, the leaked signal is not passed to the post stage of the relay switch 34.

On the other hand, upon receipt of the signal in the band 2 or 3, a voltage is not generated from the band switching circuit 42 so that the down converter 45 is made inoperative and the second input terminal 50 and the output terminal 51 of the relay switch 34 are brought into conduction. The level of the signal in the band 2 or 3 which has passed through the fourth filter 46 is adjusted by the attenuator 47. The resultant signal is passed through the fifth filter 48 and sent to the relay switch 34. At this time, the second input terminal 50 and the output terminal 51 of the relay switch 34 are conducting. The signal in the band 2 or 3 which has been passed through the relay switch 34 is amplified by the high-frequency amplifier 35 and the amplified signal is subjected to the frequency conversion by the mixer 37 and the local oscillator 38 into an intermediate frequency signal of 38.9 MHz. The signal is then amplified by the intermediate frequency amplifier 39 and the amplified signal is passed through the second filter 40 and outputted from the output terminal 41.

Even when the signal in the L band is supplied to the down converter 45, since no voltage is applied from the band switching circuit 42 to the down converter 45 in the first high-frequency circuit part 32 and is in the inoperative state, the signal in the L band is not outputted from the down converter 45. Even when the signal is leaked at a very low level and inputted to the first input terminal 49 in the relay switch 34, since the first input terminal 49 is not conductive with the output terminal 51, the signal is not supplied to the post stage of the relay switch 34.

Since the conventional tuner has the relay switch 34 to switch the receiving band, there are problems such that the capacity of the tuner is large and the price of the product is high.

It is therefore an object of the invention to realize a small tuner for receiving signals by switching a plurality of bands at low cost.

According to the invention, in order to achieve the object, there is provided a tuner comprising: a first high-frequency circuit part 2 for receiving a first band signal; a second high-frequency circuit part 3 for receiving a second band signal; and a mixer 7 for converting either the first band signal received by the first high-frequency circuit part 2 or the second band signal received by the second high-frequency circuit part 3 into an intermediate frequency signal, wherein a first high-frequency amplifier 4 is provided between the first high-frequency circuit part 2 and the mixer 7, a second high-frequency amplifier 5 is provided between the second high-frequency circuit part 3 and the mixer 7, and the first high-frequency amplifier 4 or the second high-frequency amplifier 5 is alternatively made operative.

In an embodiment of the invention, at least one of the first high-frequency amplifier 4 and the second high-frequency amplifier 5 is constructed by FETs which are cascade connected.

In an embodiment of the invention, at least one of the first high-frequency amplifier 4 and the second high-frequency amplifier 5 is constructed by a dual gate FET.

In an embodiment of the invention, the first high-frequency amplifier 4 and the second high-frequency amplifier 5 have the same configuration.

Embodiments of the invention will now be described by way of example only, with reference to the accompanying drawings in which,
Fig. 1 is a block diagram showing the configuration of a tuner of the invention.
Fig. 2 is a circuit diagram of first and second high-frequency amplifiers used for the tuner of the invention.
Fig. 3 is another circuit diagram of the first high-frequency amplifier used for the tuner of the invention.
Fig. 4 is a block diagram showing the configuration of a conventional tuner for receiving television signals.

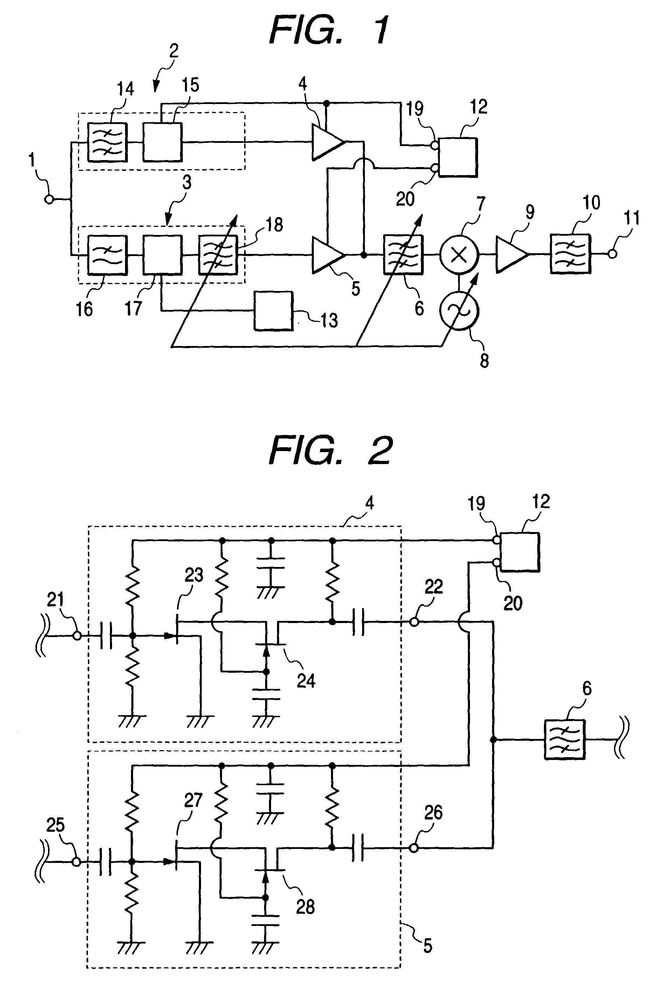

The tuner of the invention will be described hereinbelow with reference to Figs. 1 to 3. Fig. 1 is a block diagram of the tuner of the invention. Figs. 2 and 3 are circuit diagrams of high-frequency amplifiers used for the tuner of the invention.

In Fig. 1, the tuner of the invention for receiving signals while switching a plurality of bands comprises an input terminal 1, a first high-frequency circuit part 2 for frequency converting a signal in the L band as the first band, a second high-frequency circuit part 3 for receiving a signal in the band 2 or 3 as the second band, a first high-frequency amplifier 4, a second high-frequency amplifier 5, a first filter 6, a mixer 7, a local oscillator 8, an intermediate frequency amplifier 9, a second filter 10, an output terminal 11, a band switching circuit 12, and a gain control voltage generator 13. For example, a signal in any of the L band and bands 2 and 3 of European digital sound broadcasts is supplied to the input terminal 1. The frequency band of the L band as the first band is from 1,453 MHz to 1,490 MHz. The frequency band of the band 2 as the second band is from 88 MHz to 107 MHz. The frequency band of the band 3 as the second band is from 175 MHz to 239 MHz. The first high-frequency circuit part 2 has a third filter 14 and a down converter 15. A switching voltage is supplied from the band switching circuit 12 to the first high-frequency amplifier 4, the second high-frequency amplifier 5 and the down converter 15. The second high-frequency circuit part 3 has a fourth filter 16, an attenuator 17, and a fifth filter 18. A gain control voltage generated from the gain control voltage generator 13 is applied to the attenuator 17.

The frequency to be received is selected by changing the oscillation frequency of the local oscillator 8 by station selecting means (not shown). Each of the first filter 6 and the fifth filter 18 is a variable bandpass filter, by which the intermediate frequency in the pass band is changed according to a change in the oscillation frequency of the local oscillator 8.

In the case of receiving the signal in the band 2 or 3, the gain control voltage generator 13 generates a gain control voltage corresponding to the level of the signal to adjust the attenuation amount of the attenuator 17 by the gain control voltage so as to obtain an almost constant output. In the case of receiving the signal in the L band, the gain control voltage to maximize the attenuation amount of the attenuator 17 is generated. The second filter 10 is a bandpass filter and passes only the intermediate frequency signal. The third filter 14 is a bandpass filter and passes only the band signal in the L band. The fourth filter 16 is a low pass filter and passes only the band signal in the band 2 or 3. The signal in any of the bands is supplied to the input terminal 1.

Upon reception of the signal in the L band, a switching voltage is applied from the first terminal 19 of the band switching circuit 12 to the down converter 15 and the first high-frequency amplifier 4, and the down converter 15 and the first high-frequency amplifier 4 enter the operating state. At this time, the switching voltage is not supplied to the second high-frequency amplifier 5. The frequency of the L-band signal which has been passed through the third filter 14 is converted by the down converter 15 to a low frequency of 1,300 MHz and the resultant signal is sent the first high-frequency amplifier 4. The signal in the L band is amplified by the high-frequency amplifier 4. The amplified signal is passed through the first filter 6 and is frequency converted by the mixer 7 and the local oscillator 8 to an intermediate frequency signal of 38.9 MHz. The intermediate frequency signal is amplified by the intermediate frequency amplifier 9 and the amplified signal is passed through the second filter 10 and outputted from the output terminal 11.

Since the attenuation amount of the attenuator 17 in the second high-frequency circuit part 3 is the maximum at this time, the level of the signal in the band 2 or 3 to be supplied to the second high-frequency amplifier 5 is extremely low. Further, since no switching voltage is applied from the band switching circuit 12 to the second high-frequency amplifier 5, the second high-frequency amplifier 5 is not operating. The signal in the band 2 or 3 is not therefore passed to the post stage of the second high-frequency amplifier 5.

On the other hand, upon receipt of the signal in the band 2 or 3, the switching voltage is applied from the second terminal 20 of the band switching circuit 12 to the second high-frequency amplifier 5, so that the second high-frequency amplifier 5 is made operative. The signal is passed through the fourth filter 16, its level is adjusted by the attenuator 17, and the signal in the band 2 or 3 which is passed through the fifth filter 18 is passed to the second high-frequency amplifier 5. The resultant signal is amplified by the second high-frequency amplifier 5 and the resultant signal is passed through the first filter 6 and is subjected to the frequency conversion by the mixer 7 and the local oscillator 8 into an intermediate frequency signal of 38.9 MHz. The frequency converted signal is amplified by the intermediate frequency amplifier 9 and the amplified signal is passed through the second filter 10 and outputted from the output terminal 11.

Since no switching voltage is applied from the band switching circuit 12 to the down converter 15 and the first high-frequency amplifier 4, and the down converter 15 and the first high-frequency amplifier 4 are in an inoperative state, the signal in the L band is hardly transmitted to the post stage of the first high-frequency amplifier 4.

Referring to Fig. 2, the specific configuration of the first and second high-frequency amplifiers 4 and 5 will be described in detail. The first and second high-frequency amplifiers 4 and 5 have the same configuration. In the first high-frequency amplifier 4, a first single gate FET 23 and a second single gate FET 24 which are cascade connected are provided between the input terminal 21 and the output terminal 22. A switching voltage is applied from the band switching circuit 12 to the gate of the first single gate FET 23 and the gate and drain of the second single gate FET 24. Similarly, in the second high-frequency amplifier 5, a third single gate FET 27 and a fourth single gate FET 28 which are cascade connected are provided between the input terminal 25 and the output terminal 26. A switching voltage is applied from the band switching circuit 12 to the gate of the third single gate FET 27 and the gate and drain of the fourth single gate FET 28.

With the configuration, first, in the case of receiving the L-band signal, a switching voltage is applied from the band switching circuit 12 to the gate of the first single gate FET 23 and the gate and drain of the second single gate FET 24 via the first terminal 19. The L-band signal supplied to the input terminal 21 is amplified by the first single gate FET 23 and the second single gate FET 24 and the amplified signal is outputted from the output terminal 22.

At this time, since no switching voltage is applied to the third and fourth single gate FETs 27 and 28, isolation between the input terminal 25 and the output terminal 26 becomes large. Consequently, even when the signal in the band 2 or 3 is supplied to the input terminal 25, it does not appear at the output terminal 26.

On the other hand, in the case of receiving the signal in the band 2 or 3, the switching voltage is applied from the band switching circuit 12 to the gate of the third single gate FET 27 and the drain of the fourth single gate FET 28 via the second terminal 20. The signal in the band 2 or 3 supplied to the input terminal 25 is amplified by the third and fourth single gate FETs 27 and 28 and the amplified signal is outputted from the output terminal 26.

Since no switching voltage is applied to the first and second single gate FETs 23 and 24 at this time, isolation between the input terminal 21 and the output terminal 22 becomes large. Consequently, even when the L-band signal is supplied to the input terminal 21, it does not appear at the output terminal 22.

Another example of the configuration of the first high-frequency amplifier 4 will be described in detail with reference to Fig. 3. Since the second high-frequency amplifier 5 has a configuration similar to that of the first high-frequency amplifier 4, its description is omitted here. In the first high-frequency amplifier 4, a dual gate FET 29 is provided between the input terminal 21 and the output terminal 22. A switching voltage is applied from the band switching circuit 12 to the first and second gates of the dual gate FET 29.

With the configuration, in the case of receiving the L-band signal, the switching voltage is applied from the band switching circuit 12 to the first gate, the second gate, and the drain of the dual gate FET 29 via the first terminal 19. A high-frequency signal supplied to the input terminal 21 is then amplified by the dual gate FET 29 and the amplified signal is outputted from the output terminal 22.

On the other hand, in the case of receiving the signal in the band 2 or 3, since no switching voltage is applied to the dual gate FET 29, isolation between the input terminal 21 and the output terminal 22 increases to about 60 dB.

When the first and second high-frequency amplifiers 4 and 5 have the same configuration, an output impedance of the first high-frequency amplifier 4 at the time of receiving the L-band signal is equal to an output impedance of the second high-frequency amplifier 5 at the time of receiving the signal in the band 2 or 3. Consequently, the input impedance of the first filter 6 can be matched to both of the high-frequency amplifiers, so that occurrence of a reflected wave can be suppressed.

When the occurrence of the reflected wave is not a problem, the first and second high-frequency amplifiers 4 and 5 may have different configurations. For example, a dual gate FET may be used for the first high-frequency amplifier 4 and two single gate FETs may be used for the second high-frequency amplifier 5 and vice versa.

The tuner of the invention is not limited to the examples shown in the diagrams. Obviously, it can be variously modified without departing from the gist of the invention.

As described above, according to the tuner of the invention, the first high-frequency amplifier is provided at the post stage of the first high-frequency circuit part, the second high-frequency amplifier is provided at the post stage of the second high-frequency circuit part, the mixer is provided at the post stage of the first and second high-frequency amplifiers, and the first high-frequency amplifier or the second high-frequency amplifier is alternatively driven, so that the amplifiers function as band switching means. Thus, the small and cheap tuner can be achieved.

According to the tuner of the invention, at least one of the first and second high-frequency amplifiers is constructed by FETs which are cascade connected. Consequently, the isolation between the input and output terminals of the high-frequency amplifier becomes large and interference is suppressed.

According to the tuner of the invention, at least one of the first and second high-frequency amplifiers is constructed by a dual gate FET. Consequently, the number of elements can be decreased and the size of the tuner can be further reduced.

According to the tuner of the invention, the first and second high-frequency amplifiers have the same configuration. The impedances of the first and second high-frequency amplifiers can be matched with the impedance of the filter at the post stage, so that the occurrence of reflected waves can be suppressed.

## Claims

1. A tuner comprising:
a first high-frequency circuit part for receiving a first band signal;
a second high-frequency circuit part for receiving a second band signal; and
a mixer for converting either the first band signal received by the first high-frequency circuit part or the second band signal received by the second high-frequency circuit part into an intermediate frequency signal,
wherein a first high-frequency amplifier is provided between the first high-frequency circuit part and the mixer,
a second high-frequency amplifier is provided between the second high-frequency circuit part and the mixer, and
the first high-frequency amplifier or the second high-frequency amplifier is alternatively made operative.

2. A tuner according to claim 1, wherein at least one of the first and second high-frequency amplifiers is constructed by FETs which are cascade connected.

3. A tuner according to claim 1 or 2, wherein at least one of the first and second high-frequency amplifiers is constructed by a dual gate FET.

4. A tuner according to any one of claims 1 to 3, wherein the first and second high-frequency amplifiers have the same configuration.
